# EUROPEAN PATENT SPECIFICATION

(11) **EP 2 672 520 B1**
(45) Date of publication and mention of the grant of the patent: **04.07.2018**
(21) Application number: 12171065.1
(22) Date of filing: 06.06.2012
(51) Int. Cl.: C23C 18/16, C23C 18/18, C23C 18/40, H01L 21/288, H01L 31/0224

(54) **Method for electroless deposition of a copper layer, electroless deposited copper layer and semiconductor component comprising said electroless deposited copper layer**
Verfahren zur galvanischen Ablagerung einer Kupferschicht, galvanisch abgelagerte Kupferschicht und Halbleiterkomponente mit der galvanisch abgelagerten Kupferschicht
Procédé de dépôt anélectrolytique d'une couche de cuivre, couche de cuivre déposée par dépôt anélectrolytique et composant semi-conducteur comprenant ladite couche de cuivre déposée par dépôt anélectrolytique

(43) Date of publication of application: 11.12.2013
(73) Proprietor: SEMIKRON Elektronik GmbH & Co. KG, 90431 Nürnberg (DE)
(72) Inventor: Soares Ceasar Da Silva Franco, Cibele, Parque São Paulo - Cotia - São Paulo (BR)
(74) Representative: Walcher, Armin

(56) References cited:
- EP-A1- 1 876 262
- JP-A- 2011 068 954
- US-A1- 2007 048 447
- US-A1- 2008 121 276
- US-A1- 2008 248 194
- US-A1- 2010 275 989

## Description

The present invention is directed to a method for electroless deposition of a copper-layer on a semiconductor substrate, an electroless deposited copper layer suitable for wire-bonding obtainable by said method, and a semiconductor component comprising at least one of said electroless deposited copper layer.

Power semiconductor devices are semiconductor devices used for example as switches or rectifiers in power electronic circuits. Power semiconductor devices withstand very high reverse breakdown voltage of from 200 V up to 8500 V and are also capable of carrying high current in the range of 300 up to 12000 A.

Especially, volume conductive power semiconductor devices made from mono-crystalline semiconductor material are reduced in thickness in order to improve the electrical properties, for instance in order to reduce the conducting and/or switching losses during operation. Currently available power diodes of a voltage class of 1700 V, for example, posses a thickness of from 250 µm to 300 µm.

Electrical contacts to a power semiconductor device are effected by contact metal layers applied on at least one surface of the power semiconductor device. These contact metal layers may be further interconnected by metal bonds.

One common metal used for contact metal layers and/or metal bonds is aluminum. Aluminum is relatively inexpensive compared to other conductive materials and has low resistivity. Furthermore, aluminum is relatively easy to etch.

A replacement material for aluminum is copper, which has better electrical conductivity, lower resistivity and higher thermal conductivity than aluminum.

It is known in the art that pure copper used for Cu-metallization is more robust against electromigration than aluminum. Copper wires can withstand approximately five times more current density than aluminum wires while assuming similar reliability requirements. This is mainly due to the higher electromigration activation energy levels of copper, caused by its electrical and thermal conductivity as well as its higher melting point.

Metal bonds may be formed by wire bonding, which is a cost-effective and flexible technology for forming interconnections using bond wires having diameters of from 12 µm up to several hundred micrometers for high-powered applications.

However, wire bonding interconnections result in a punctual applied current, which has to be distributed homogenously via the contact metal layer to the semiconductor device.

There is a demand to provide an improved copper layer being particularly useful for wire-bonding. US2008/0121276 discloses a method of electroless deposition of thick copper layers on solar cells.

US2008/0248194 discloses methods of electroless deposition of relatively thin copper layers for TFT-LCDs.

JP2011068954 discloses an electroless copper plating solution for through-silicon vias. The plating solution may comprise non-ionic surfactants and a cyanide compound.

Therefore, an object underlying the present invention is the provision of a method for deposition of a contact metal layer on a semiconductor device, preferably a power semiconductor device. It is desirable to have a method which allows the deposition of a relatively thick contact metal layer in a short period of time, wherein said thick layer is suitable for wire-bonding and is able to withstand high operating currents applied to an semiconductor device, preferably a power semiconductor device.

The object is solved by providing a method for electroless deposition of a copper-layer on a semiconductor substrate according to claim 1.

The method for electroless deposition of a copper-layer on a semiconductor substrate comprises the steps of:
a) providing a semiconductor substrate,
b) contacting said semiconductor substrate with an aqueous solution comprising at least one colloidal metal and/or salt of a metal, said metal being selected from the group consisting of Ag, Au, Pd, Pt, Rh, Sn, and mixtures thereof,
c) optionally, rinsing said semiconductor substrate obtained in step b),
d) contacting said semiconductor substrate with an aqueous solution containing at least one reducing agent,
e) optionally, rinsing said semiconductor substrate obtained in step d),
f) contacting said semiconductor substrate with a copper plating solution containing
   at least one water soluble copper salt,
   at least one complexing agent for copper ions,
   at least one reducing agent,
   at least one agent for adjusting the pH to a value of greater than 9.0
   with the proviso that said agent is not NaOH,
   at least one water soluble cyano metal compound,
   at least one non-ionic surfactant, and
   water,
   at a temperature below the boiling point of the copper plating solution resulting in the formation of a copper-layer,
g) optionally, rinsing said semiconductor substrate obtained in step f), and
h) annealing said copper-layer.

Preferred embodiments of the method of the present invention are outlined in dependent claims 2 to 12.

The inventors surprisingly found out that a copper layer produced by the method of the invention has a particular roughness which means that a copper layer produced by the method of the invention are more rough than copper layers produced by conventional deposition methods. Moreover, the copper layer produced by the method of the invention is surprisingly thick and has preferably a thickness of at least 3.0 µm what is necessary to form the rough surface. The particular roughness of the produced copper layer is extremely useful for wire bonding. The wire bonding is a process of micro welding by which the wire is firmly bonded to the rough copper layer. The rough surface allows producing a strong wire bond, for example, by forcefully rubbing the wire on the rough copper surface. Thereby, a wire bond is generated by thermo-compression. Alternatively, the wire can be bonded to the rough copper surface by applying vibrational energy, e.g. ultrasonic waves, to the wire being in contact with the copper layer. It is also possible to combine the thermo-compression process and the use of vibrational energy, e.g. ultrasonic waves.

Therefore, the rough surface of the copper layer, produced by the method of the invention, is of particular importance to generate strong wire bonds between the wire and the copper layer.

The object is further solved by provision of an electroless deposited copper layer suitable for wire-bonding obtainable by the method according to any one of claims 1 to 12 and having a thickness of from 3.0 µm to 12 µm, preferably of from 4.0 µm to 9.0 µm. The deposited copper layer is characterized by a solid structure. The solid structure is due to the fact that the copper layer is applied by one deposition step, namely by step f) of the method of the invention. That is to say, the deposited copper layer does not have a layered structure what would be obtained when applying the copper in several deposition steps. A layered structure is disadvantageous in that delamination can occur during or after wire-bonding. Usually, high voltage and high voltage current is applied to a power semiconductor inducing heat in the semiconductor. A solid structure of the copper layer ensures that the wire bonds remain reliably fixed to the copper layer and that no delamination phenomenon can occur in the copper layer under operation.

Preferred embodiments of the electroless deposited copper layer of the present invention are outlined in dependent claims 14 and 15.

The object is further solved by providing a semiconductor component having a first surface and an opposite second surface comprising at least one pn-junction having at least one p-doped volume and at least one n-doped volume, wherein said at least one p-doped volume, optionally coated with a first contact metal layer, is arranged at said first surface of said semiconductor component forming a first contact-area and wherein said at least one n-doped volume, optionally coated with a second contact metal layers, is arranged at said second surface of said semiconductor component forming a second contact-area and wherein an electroless deposited copper-layer according to any one of claims 13 to 15 is arranged on said first contact-area.

Suitable semiconductor substrates are known in the art. Preferably, the semiconductor substrate may be a semiconductor substrate of a certain conductive type, such as a p-type and/or an n-type conductive type.

In a preferred embodiment, the semiconductor substrate comprises at least one pn-junction comprising at least one p-doped volume and at least one n-doped volume.

The semiconductor is preferably a plate-like substrate having a first surface and an opposite second surface.

It is further preferred, that said semiconductor substrate having a first surface and an opposite second surface comprises a plurality of semiconductor components, wherein each of said semiconductor components comprises at least one pn-junction having at least one p-doped volume and at least one n-doped volume, wherein said at least one p-doped volume is arranged at said first surface of said substrate forming a first contact-area and wherein said at least one n-doped volume is arranged at said second surface of said substrate forming a second contact-area.

In a preferred embodiment, said least one p-doped volume is directly coated with a first contact metal layer forming a first contact-area.

In a further preferred embodiment, said at least one n-doped volume is directly coated with a second contact metal layers forming a second contact-area.

In a preferred embodiment, said first contact metal layer and/or said second contact metal layer is an adhesion promoting layer having a thickness of less than 500 nm and preferably containing nickel or consisting of nickel.

In a further preferred embodiment, said first contact metal layer and/or said second contact metal layer may be applied by physical vapor deposition, sputtering or chemical vapor deposition prior to step a) of the method of the present invention.

In a further preferred embodiment, said semiconductor component is arranged as a wafer assembly comprising a plurality of semiconductor components.

Preferably, said second contact-areas of all semiconductor components of the wafer assembly are in direct contact to each other forming a continuous contact-area.

Preferably, said first contact-areas of all semiconductor components of the wafer assembly are spaced apart from each other forming a discontinuous contact-area.

Further preferably, said first contact-areas of all semiconductor components arranged on the wafer assembly are spaced apart from each other by a coating, preferably a passivating coating or isolating coating.

Suitable materials for said coating, preferably passivating or isolating coating, are known in the art and include organic resins.

A suitable material is, for example, wepelan plating resist SD 2154E commercially available from Lackwerke Peters (Kempen, DE)

Another suitable material is, for example, Rhenodux-Screen-ink 220-CX-220449 commercially available from Hoefer GmbH Lackfabrik (Roth, DE).

Further preferably, said plurality of semiconductor components, arranged as a wafer assembly, are separated from each other after step h) by methods known in the art. The separation into single semiconductor components can be effected by, e.g., cutting, stamping, punching, sawing, breaking, etc..

The method of the present invention provides at least one, preferably one, electroless deposited copper-layer on said first contact-area.

Said at least one, preferably one, electroless deposited copper is deposited by method of the present invention in a thickness of from 3.0 µm to 12 µm, preferably of from 4.0 µm to 9.0 µm, further preferably of from 5.0 µm to 8.0 µm, preferably at a deposition rate of from 1 µm/h to 5 µm/h, further preferred of from 1.5 µm/h to 4.5 µm/h, further preferably of from 2 µm/h to 4 µm/h.

In step b) of the method of the present invention said semiconductor substrate is contacted with an aqueous solution comprising at least one salt of a metal selected from the group consisting of Ag, Au, Pd, Pt, Rh, Sn, and mixtures thereof, Preferably, the at least one metal salt is soluble, preferably water soluble.

According to another embodiment of the invention, said aqueous solution comprises at least one metal selected from the group consisting of Ag, Au, Pd, Pt, Rh, Sn, and mixtures thereof, in a colloidal form.

A suitable aqueous solution comprising at least one metal in colloidal form is, for example, sold by Dow (Midland, USA) under the trade name "CATAPOSIT® 44 Catalyst", comprising a colloidal tin-palladium catalyst.

According to another embodiment of the invenion, said water soluble metal salt is preferably selected from the group consisting of sulfates, halides, nitrates, acetates and other organic and inorganic acid salts of said metal and mixtures thereof. Suitable water soluble metal salts may be selected from the group consisting of PdCl₂, AuCl₃, AuCl₃ x HCl and SnCl₂.

In a further preferred embodiment, said at least one metal selected from the group consisting of Ag, Au, Pd, Pt, Rh, Sn, and mixtures thereof, and/or at least one water soluble metal salt thereof is present in the aqueous solution used in step b) of the method of the present invention in an amount of from 0.001 mol/l to 1.0 mol/l, preferably in an amount of from 0.0015 mol/l to 0.8 mol/l, further preferably in an amount of from 0.0015 mol/l to 0.75 mol/l.

The copper plating solution used in step f) of the method of the present invention contains at least one, preferably one, water soluble copper salt.

In a preferred embodiment, said water soluble copper salt is a water soluble copper (II) salt selected from the group consisting of sulfates, halides, nitrates, acetates and other organic and inorganic acid salts of copper and mixtures thereof, preferably a water soluble copper (II) salt selected from the group consisting of CuSO₄, CuCl₂, Cu(NO₃)₂, Cu(BF₄)₂, Cu(OAc)₂ and mixtures thereof, further preferably CuSO₄.
In a further preferred embodiment, said water soluble copper salt is present in the copper plating solution used in step f) of the method of the present invention in an amount of from 0.01 mol/l to 4.0 mol/l, preferably in an amount of from 0.013 mol/l to 1.2 mol/l, preferably in an amount of from 0.02 mol/l to 0.8 mol/l, further preferably in an amount of from 0.03 mol/l to 0.75 mol/l, based on the weight of the copper solution.
The copper plating solution used in step f) of the method of the present invention further contains at least one, preferably one, complexing agent for copper ions. Suitable complexing agents for copper ions are known in the art and may be selected from the group consisting of tartrate, e.g. potassium and/or sodium tartrate, ethylenediamine-N,N,N',N'-tetraacetic acid, sodium mono-, di-, tri-, and/or tetrasodium salts of ethylenediamine-N,N,N',N'-tetraacetic acid, modified ethylenediamineacetates such as N-(2-hydroxyethyl)ethylenediamine-N,N',N'-triacetate, (1,2-cyclohexylenedinitrilo)-tetraacetic acid, nitrilotriacetic acid and its alkali salts, gluconic acid, gluconates, triethanolamine, glucono-gamma-lactone and mixtures thereof.

Other agents suitable for use as copper ion complexing agents are disclosed, for example, in US 2,996,408, US 3,075,856, US 3,075,855 and US 2,938,805. In a preferred embodiment, said at least one complexing agent for copper ions is present in the copper plating solution used in step f) of the method of the present invention in an amount of from 0.5 to 40 times the moles of the water soluble copper salt, preferably in an amount of from 0.7 to 35 times the moles of the water soluble copper salt, further preferred in an amount of from 1.5 to 25 times the moles of the water soluble copper salt, still further preferred in an amount of from 2 to 15 times the moles of the water soluble copper salt.
In step d) of the method of the present invention said semiconductor substrate is contacted with an aqueous solution containing at least one reducing agent. Furthermore, the copper plating solution used in step f) of the method of the present invention contains at least one reducing agent.
In a preferred embodiment of the invention, said at least one reducing agent used in step d) of the method of the present invention is the same as the at least one reducing agent used in the copper plating solution used in step f) of the method of the present invention.
However, it is also possible that said at least one reducing agent used in step d) of the method of the present invention is different from said at least one reducing agent used in step f) of the method of the present invention.
Reducing agents for copper ions suitable for use as at least one reducing agent in step d) and/or step f) of the method of the invention in an alkaline copper plating solution are known in the art and are described, for example, in US 3,485,643 or US 5,965,211. Said at least one reducing agent used in step d) and/or step f) is preferably selected from the group consisting of formaldehyde, formaldehyde derivatives such as paraformaldehyde, glyoxylic acid, hypophosphite salts such as sodium hypophosphite, amine boranes such as dimethyl amine borane (DMAB), sugar such as glucose, and mixtures thereof, further preferably formaldehyde, glyoxylic acid and mixtures thereof.
Further preferably said at least one reducing agent used in step d) and/or step f) is formaldehyde.

In a further preferred embodiment, said at least one reducing agent is present in the copper plating solution used in step f) of the method of the present invention in an amount of from 0.01 mol/l to 4.0 mol/l, preferably in an amount of from 0.05 mol/l to 3.5 mol/l, further preferably in an amount of from 0.07 mol/l to 2.7 mol/l, further preferably in an amount of from 0.09 mol/l to 0.9 mol/l.

In a further preferred embodiment, said at least one reducing agent is present in the aqueous solution used in step d) of the method of the present invention in an amount of from 0.1 % by weight to 32 % by weight, preferably in an amount of from 0.4 % by weight to 28 % by weight, further preferably in an amount of from 0.57 % by weight to 22 % by weight, further preferably in an amount of from 0.73% by weight to 1.63% by weight, respectively, based on total weight of the aqueous solution.

The copper plating solution used in step f) of the method of the present invention contains at least one agent for adjusting the pH to a value of greater than 9.0 with the proviso that the agent is not NaOH.

In a preferred embodiment, said at least one agent for adjusting the pH to a value of greater than 9.0 is selected from the group consisting of potassium hydroxide, tetramethylammonium hydroxide (TMAH) and mixtures thereof.

In a further preferred embodiment, said at least one agent for adjusting the pH to a value of greater than 9.0 is potassium hydroxide or a mixture of potassium hydroxide and tetramethylammonium hydroxide.

The inventors surprisingly found out, that the use of potassium hydroxide, tetramethylammonium hydroxide (TMAH) or mixtures thereof in the method of the present invention as said at least one agent for adjusting the pH to a value of greater than 9.0 resulted in the deposition of bright copper layers, with high deposition rates of about 3 µm/h.

In contrast, using sodium hydroxide or a mixture of sodium hydroxide and TMAH resulted in the deposition of copper layers with a very dark surface. The dark surface might be caused by a change of the morphology of the deposited copper layer and/or surface oxidation of the deposited copper layer.

The inventors observed that wire bonding a dark copper surface resulted in wire bonds having declined bond strength.

In a further preferred embodiment, the pH of the copper plating solution used in step f) of the method of the present invention is adjusted to a value of from 9.1 to 13.5, preferably to a value of from 9.5 to 13.0, preferably to a value of from 10.1 to 12.9, further preferably to a value of from 11.1 to 12.6.

In the present application, indicated pH-values are measured at a temperature at which step f) of the method of the present invention is conducted, preferably at a temperature in the range of from 15°C to below 100°C, preferably in the range of from 20°C to 95°C, further preferred in the range of from 25°C to 80°C, further preferred in the range of from 50°C to 80°C.

In a further preferred embodiment, indicated pH-values are measured at a temperature of 50°C.

The copper plating solution used in step f) of the method of the present invention further contains at least one water soluble cyano metal compound.

In a preferred embodiment, said at least one water soluble cyano metal compound is selected from the group consisting of A₃[M³⁺(CN)₆], A₄[M²⁺(CN)₆] and mixtures thereof, wherein A is selected from the group consisting of Na⁺, K⁺, Li⁺, NH₄⁺ and mixtures thereof and M is selected from the group consisting of Fe, Mn, Cr, Co and mixtures thereof. It is further preferred, that said at least one water soluble cyano metal compound is selected from the group consisting of K₃[Fe³⁺(CN)₆], K₄[Fe²⁺(CN)₆] and mixtures thereof.

In another preferred embodiment, said at least one water soluble cyano metal compound is present in the copper plating solution used in step f) of the method of the present invention in an amount of from 0.005 g/l to 50 g/l, preferably in an amount of from 0.01 g/l to 25 g/l, further preferably in an amount of from 0.2 g/l to 2.5 g/l. The copper plating solution used in step f) of the method of the present invention further contains at least one nonionic surfactant. The inventors surprisingly found out that when using ionic surfactants the stability of the copper plating solution is impaired, so that the copper plating solution has to be changed frequently during a copper plating process. Furthermore, it turned out that the ductility of the produced copper layer is reduced if an ionic surfactant had been used in the copper plating solution. An increased ductility of the copper layer is obtained if a nonionic surfactant had been used. An increased ductility of the copper layer facilitates the wire-bonding when producing a semiconductor device, especially a power semiconductor device. In a preferred embodiment, said at least one nonionic surfactant is selected from the group consisting of polyoxyalkylene glycol aryl ethers, polyoxyalkylene glycol alkyl ethers, polyoxyalkylene glycol alkylaryl ethers and phosphates thereof and mixtures thereof.
The term "alkyl" means linear or branched alkyl radicals having 1 to 10 C atoms, preferably 2 to 6 C atoms.
The term "aryl" means an aromatic ring system having preferably 6 to 10 C atoms. According to a preferred embodiment "aryl" means "phenyl". The term "alkylaryl" means an alkyl substituted aromatic ring system, the ring system having preferably 6 to 10 C atoms and the alkyl group having 1 to 6 C atoms. According to a preferred embodiment "aryl" means phenyl.
The term "alkylene" means linear or branched alkylene radicals having 2 to 10 C atoms, preferably 3 to 6 C atoms. According to a preferred embodiment of the invention alkylene means ethylene and/or propylene.
Usually the nonionic surfactant comprises 2 to 50, preferably 3 to 25, further preferred 4 to 15, oxyalkylene units.

It is further preferred, that said polyoxyalkylene glycol alkylaryl ether phosphate is a polyethoxy nonylphenoxy ether phosphate having preferably from 2 to 50, further preferred from 5 to 21, ethylene oxide units.

A suitable alkylaryl polyoxyethylene glycol phosphate ester is for example sold by Rhodia (Courbevoie, France) under the trade name "RHODAFAC® RE 610".

In a further preferred embodiment, said polyoxyalkylene glycol alkylaryl ether is a polyethylene glycol-[4-(1,1,3,3-tetramethylbutyl)-phenyl]-ether having preferably 2 to 50, further preferred 5 to 21, ethylene oxide units.

A suitable polyethylene glycol-[4-(1,1,3,3-tetramethylbutyl)-phenyl]-ether having 5 to 21 ethylene oxide units is for example sold by Dow (Midland, USA) under the trade name "Triton® X-100", having an average number of ethylene oxide units of 9.5.

In another preferred embodiment, said at least one nonionic surfactant is present in the copper plating solution used in step f) of the method of the present invention in an amount of from 0.005 g/l to 10 g/l, preferably in an amount of from 0.009 g/l to 5 g/l, further preferably in an amount of from 0.01 g/l to 2 g/l.

In step f) of the method of the present invention said semiconductor substrate is contacted with a copper plating solution at a temperature below the boiling point of the copper plating solution resulting in the formation of a copper-layer.

In a preferred embodiment, step f) of the method of the present invention is conducted at a temperature in the range of from 15°C to below 100°C, preferably in the range of from 20°C to 95°C, further preferred in the range of from 25°C to 80°C, further preferred in the range of from 50°C to 80°C.

In step h) of the method of the present invention said copper-layer obtained in step f) is annealed, preferably by applying heat of a temperature in the range of from 100°C to below 300°C, preferably in the range of from 120°C to 250°C, further preferred in the range of from 160°C to 200°C, to said copper-layer.

In the method of the present invention said semiconductor substrate is optionally and preferably rinsed in steps c), e), and/or g) in order to remove trace amounts of the respective solutions used in steps b), d), and/or f) of the method of the present invention.

In a preferred embodiment, said semiconductor substrate is rinsed in steps c), e), and/or g) with aqueous solution, preferably water, more preferably deionized water, or an organic solvent. The deionized water may optionally be in admixture with an organic solvent. Preferably, any organic solvent which is a volatile organic solvent or which is easily volatilized can be used for rinsing the semiconductor substrate.

The electroless deposited copper layer of the present invention is obtainable by the method of the present invention.

The electroless deposited copper layer of the present invention has a thickness of from 1.0 µm to 12 µm, preferably of from 3.0 µm to 15 µm, further preferably of from 8.0 µm to 12 µm. The electroless deposited copper layer is particularly suitable for wire-bonding.

In the wire bonding process a metal wire is attached, preferably welded, to the electroless deposited copper layer of the present invention. During that process of attaching, preferably welding, of the wire to the copper surface an intermetallic region between the metal wire and the copper layer is formed at the contact area of at least a few thousand atoms thickness formed by melting of metal in the wire bonding process.

The energy required to rise the temperature oft his thin contact area can preferably be supplied in the form of temperature, pressure, ultrasonic vibration or combinations of thereof.

In a preferred embodiment, said copper-layer consists of at least 90 % by weight, preferably of at least 95 % by weight, more preferably of at least 98 or 99 % by weight of copper, based on the total weight of the copper layer. According to another preferred embodiment the copper layer contains substantially, preferably only, of copper.

In a further preferred embodiment, said copper-layer has a surface roughness in the range of from 2 % to 6 %, preferably of from 2.5 % to 5 %, of the total thickness of the layer. Preferably, the surface roughness is measured with a surface roughness measurement instrument, such as Surftest SJ-210 (Mitutoyo, Kawasaki, Japan).

A semiconductor component of the present invention has a first surface and an opposite second surface comprising at least one pn-junction having at least one p-doped volume and at least one n-doped volume, wherein said at least one p-doped volume, optionally coated with a first contact metal layer, is arranged at said first surface of said semiconductor component forming a first contact-area and wherein said at least one n-doped volume, optionally coated with a second contact metal layers, is arranged at said second surface of said semiconductor component forming a second contact-area and wherein an electroless deposited copper-layer according to any of claims 13 to 15 is arranged on said first contact-area.

In a preferred embodiment the semiconductor component of the present invention has a first surface and an opposite second surface comprising at least one pn-junction having at least one p-doped volume and at least one n-doped volume, wherein said at least one p-doped volume, coated with a first contact metal layer, is arranged at said first surface of said semiconductor component forming a first contact-area and wherein said at least one n-doped volume, coated with a second contact metal layers, is arranged at said second surface of said semiconductor component forming a second contact-area and wherein an electroless deposited copper-layer according to any of claims 13 to 15 is arranged on said first contact-area.

According to a preferred embodiment, said semiconductor component is a volume conductive semiconductor component, such as a volume conductive diode, a thyristor or a transistor.

According to another preferred embodiment, said semiconductor component is a photodiode, preferably a polycrystalline photodiode or a solar cell.

In a preferred embodiment, said first contact metal layer and/or said second contact metal layer is an adhesion promoting layer having a thickness of less than 500 nm and preferably containing nickel or consisting of nickel.

In a further preferred embodiment, said first contact metal layer and/or said second contact metal layer acts as diffusion barrier layer, preferably suppressing diffusion and/or electromigration of copper atoms into the semiconductor substrate.

Suitable materials, which suppress diffusion and/or electromigration of copper atoms into the semiconductor substrate, are known in the art. Examples include transition metals, borides thereof, carbides thereof, nitrides thereof, silicides thereof or mixtures thereof.

In a further preferred embodiment, said first contact metal layer and/or said second contact metal layer contains a nickel boride or consists of a nickel boride. Preferably said nickel boride is Ni₃B, Ni₂B, Ni₄B₃, NiB or a mixture thereof.

It is further preferred, that said plurality of semiconductor components are arranged as a wafer assembly.

Preferably, said second contact-areas of all semiconductor components of the wafer assembly are in direct contact to each other forming a continuous contact-area.

Further preferably, said first contact-areas of all semiconductor components of the wafer assembly are spaced to each other forming a discontinuous contact-area.

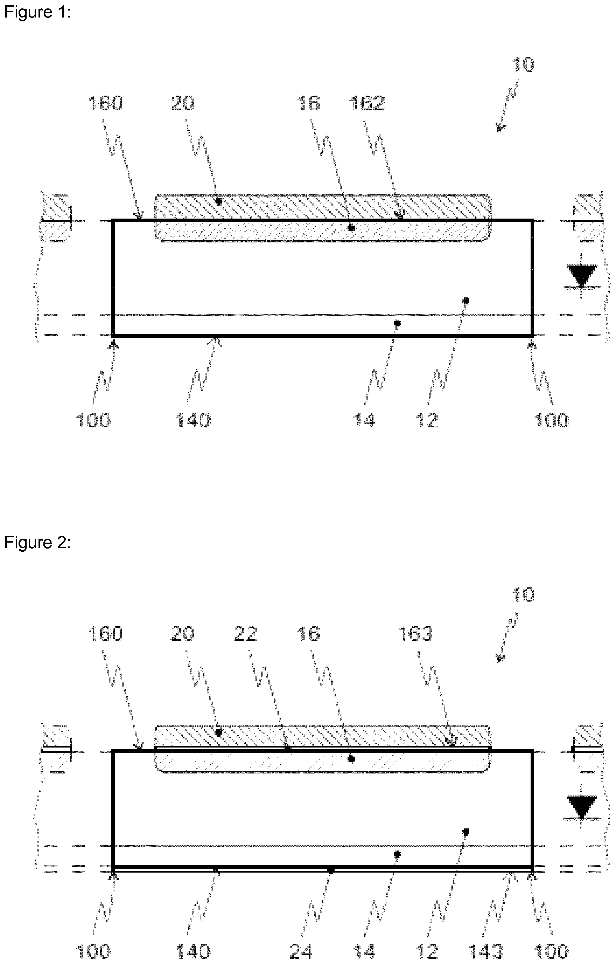

The present invention is further illustrated by Figures 1 to 6 and by the following examples that by no means limit the scope of the invention.

### Figures

Figure 1 illustrates a preferred embodiment of a semiconductor component 10 of the present invention. Neighboring semiconductor components 10 of a wafer assembly are depicted with dashed lines separated by borders 100.
   The semiconductor component 10 is exemplified as a power diode having one mono-crystalline n-doped volume 12 and a higher n-doped volume 14 arranged adjacently to each other. The n-doped volume 12 has a first surface 160 which is arranged oppositely with respect to the higher n-doped volume 14. The higher n-doped volume 14 has a second surface 140 which is arranged oppositely with respect to the n-doped volume 12.
   A p-doped volume 16 extends from the first surface 160 into the n-doped volume 12 forming a trough-shaped volume. The p-doped volume 16 does not completely extend laterally to the borders 100 thereby forming a gap to other semiconductor components of said wafer assembly.
   The gap formed at the first surface 160 between p-doped volume 16 and the borders 100 of semiconductor component 10 may be coated with a removable coating in order to prevent deposition of copper in that area.
   The surface of the p-doped volume 16, arranged oppositely to the surface of the p-doped volume 16 which contacts the n-doped volume 12, forms a first contact-area 162 of the power diode. The electroless deposited copper-layer 20 is arranged on the first contact-area 162 of the power diode.
   The surface of the higher n-doped volume 14 arranged oppositely to the surface of the higher n-doped volume 14, which contacts the mono-crystalline n-doped volume 12, forms the second surface 140 which is the second contact-area of the power diode.
Figure 2 illustrates another preferred embodiment of a semiconductor component 10 of the present invention. Neighboring semiconductor components 10 of a wafer assembly are depicted with dashed lines separated by borders 100.
   The semiconductor component 10 is exemplified as a power diode having one mono-crystalline n-doped volume 12 and a higher n-doped volume 14 arranged adjacently to each other. The n-doped volume 12 has a first surface 160 which is arranged oppositely with respect to the higher n-doped volume 14. The higher n-doped volume 14 has a second surface 140 which is arranged oppositely with respect to the n-doped volume 12.
   A p-doped volume 16 extends from the first surface 160 into the n-doped volume 12 forming a trough-shaped volume. The p-doped volume 16 does not completely extend laterally to the borders 100 thereby forming a gap to other semiconductor components of said wafer assembly.
   The gap formed at the first surface 160 between p-doped volume 16 and the borders 100 of semiconductor component 10 may be coated with a removable coating in order to prevent deposition of contact metal and/or copper in that area.
   The surface of the p-doped volume 16, arranged oppositely to the surface of the p-doped volume 16 which contacts the n-doped volume 12, is coated with a first contact metal layer 22. The surface of the first contact metal layer 22, arranged oppositely to the surface of the first contact metal layer 22, which contacts the p-doped volume 16, forms a first contact-area 163 of the power diode. The electroless deposited copper-layer 20 is arranged on the first contact-area 163 of the power diode.
   The surface of the higher n-doped volume 14 arranged oppositely to the surface of the higher n-doped volume 14, which contacts the mono-crystalline n-doped volume 12, is coated with a second contact metal layer 24.
   The surface of the second contact metal layer 24, arranged oppositely to the surface of the second contact metal layer 24, which contacts the higher n-doped volume 14, forms a second contact-area 143 of the power diode.

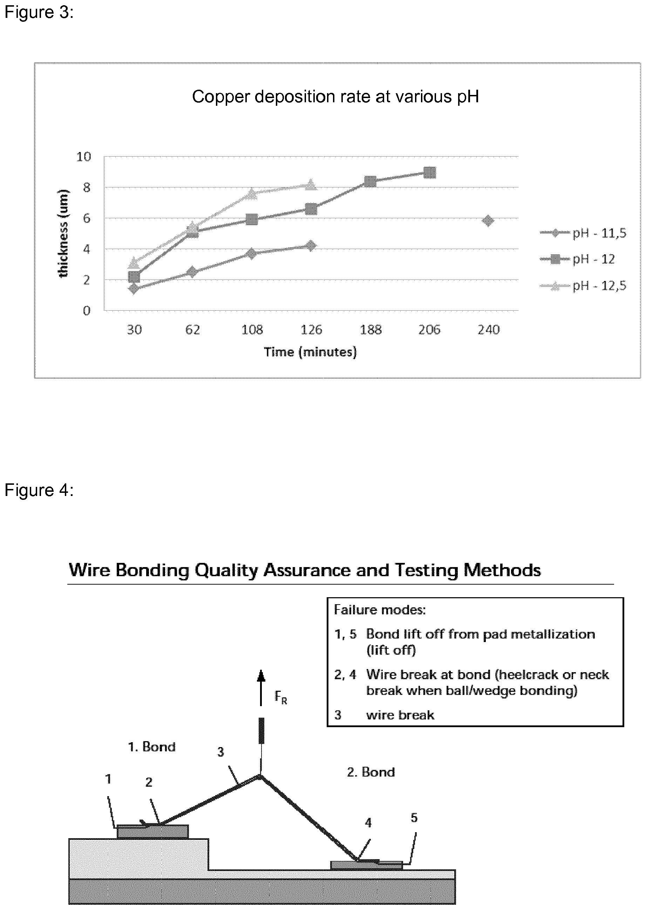

Figure 3 shows the thickness of electroless deposited copper layers at different pH. The pH was adjusted at a temperature of 50°C with KOH to 11.5, 12, or 12.5, respectively. The thickness of the electroless deposited copper layers was determined as outlined in Examples 16, 17, and 18.
Figure 4 illustrates the principle behind wire bond testing. A hook is positioned underneath the wire to be tested. A force F_{R} is applied in the Z axis, depicted by an arrow in Figure 4, either until the bond breaks (destructive testing) or a predefined force is reached (non-destructive testing). The application of force F_{R} might result in a bond failure, either by bond lift off from pad metallization or wire break.

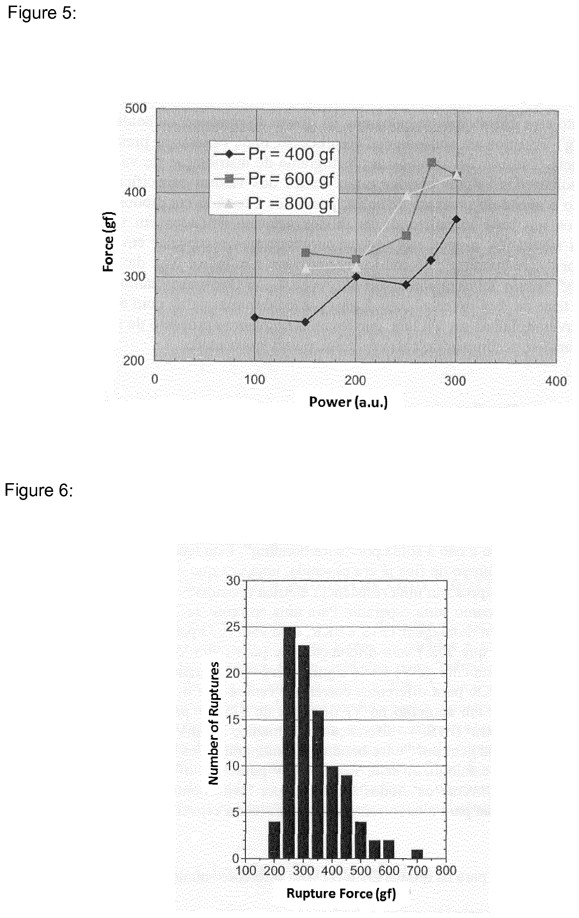

Figure 5 shows the rupture force necessary for bond break as a function of bonding power and bonding pressure for Cu-coated glass passivated diode chips which were wire bonded with an aluminum wire having a diameter of 300 µm. All bondings were done with the indicated bonding pressure (Pr) of 400 gf (gram force), 600 gf or 800 gf, respectively, and a bonding power between 100 to 300 arbitrary units (a.u.).
Figure 6 shows the distribution of bonding failures as a function of pulling force of Cu-coated glass passivated diode chips which were wire bonded with an aluminum wire having a diameter of 300 µm. All the bondings were done with 600 gf (gram force) of pressure and power of 200 arbitrary units (a.u.) and with 0.1 s of applied power. The minimum bond strength as specified by MIL STD 750B, method 2037, is 140 gf for an aluminum wire with 300 µm diameter. No bonding failed below 140 gf.

### Examples

Examples 1 to 4, 6 to 10, 12, and 15 to 17 are Examples illustrating the invention and Examples 5, 11, 13 to 14, and 18 are comparative Examples.

If not indicated otherwise, "%" denotes "% by weight" in following examples.

Silicon wafers manufactured by float zone process were obtained from Siltronic AG (München, DE) with the following characteristics:
- diameter from 4 inches (101.6 mm) up to 6 inches (152.4 mm),
- thickness from 300 µm up to 350 µm,
- crystal orientation: 1-1-1,
- resistivity range 40 to 100 ohm.

For further testing square diode chips with a size of 5.6 mm x 5.6 mm and having one pn-junction were processed into the silicon wafers by methods known in the art.

### Copper Electroless Activation Process:

Silicon wafers where dipped into an acidic, aqueous solution comprising 0.00175 g/l PdCl₂ and having a pH of 0 for 4 minutes at a temperature of about 25°C, followed by a short rinsing step with dionised water for 10 sec.

After rinsing, the silicon wafers where further dipped into an aqueous formaldehyde solution containing 100g/l formaldehyde having a pH of 4.5 for 4 minutes at a temperature of 25°C, followed by a short rinsing step with deionized water for 10 sec.

### Copper Electroless Process:

After rinsing, the silicon wafers were subjected to a copper plating solution for 180 up to 210 minutes at a temperature of 65°C, followed by a short rinsing step with deionized water for 10 sec.

Several compositions of copper plating solutions were tested. The compositions of the respective copper plating solutions tested are outlined below, in tables 1 to 5.

**Table 1: Composition of electroless copper plating solutions with different Copper concentration**

| | Ex.1 | Ex.2 | Ex.3 | Ex.4 | Comp.Ex.5 |
|---|---|---|---|---|---|
| CuSO₄ × 5H₂O [mol/l] | 0.01 | 0.02 | 0.03 | 0.075 | 5 |
| EDTA acid [mol/l] | 0.089 | 0.089 | 0.089 | 0.089 | 0.089 |
| Formaldehyde [mol/l] | 0.123 | 0.123 | 0.123 | 0.123 | 0.123 |
| KOH [pH at 50°C] | 12 | 12 | 12 | 12 | 12 |
| K₃[Fe(CN)₆] [mg/l] | 400 | 400 | 400 | 400 | 400 |
| 1% RE 610 surfactant [ml/l] 10 | 10 | 10 | 10 | | 10 |

All solutions were adjusted to a final volume of 2 liters and were subsequently aerated with air at a rate of 0.5 cubic foot per hour. Five silicon wafers were processed with the copper activation process as description above and after that each one was subsequently introduced in one of the respective test solutions outlined in table 1 under the conditions described above for the copper electroless process.

The test solution used in Example 1 resulted in a low copper deposition rate of below 0.5 µm/h, after 240 minutes. The test solution used in Comparative Example 5 became instable and copper precipitation from the copper plating solution occurred. Good results were obtained with test solutions used in Examples 2, 3 and 4 which resulted in a copper deposition rate of 1.5 µm/h and 3 µm/h, after 126 minutes, respectively.

Furthermore, various Copper (II) salts, such as Cu(BF₄)₂, or CuCl₂, were tested, which resulted in similar copper deposition rates.

The replacement of K₃[Fe(CN)₆] with K₄[Fe(CN)₆] did not influence the copper deposition rates significantly.

Three complexing agents, EDTA, TEA (triethanolamine) and CDTA ((1,2-Cyclohexylenedinitrilo)tetraacetic acid) were tested.

The best results were achieved with the EDTA.

**Table 2: Composition of electroless copper plating solutions with different HCHO concentration.**

| | Ex.6 | Ex.7 | Ex.8 |
|---|---|---|---|
| CuSO₄ × 5H₂O [mol/l] | 0.03 | 0.03 | 0.03 |
| EDTA acid [mol/l] | 0.089 | 0.089 | 0.089 |
| Formaldehyde [mol/l] | 0.06 | 0.123 | 0.2 |
| KOH [pH at 50°C] | 12 | 12 | 12 |
| K₃[Fe(CN)₆] [mg/l] | 400 | 400 | 400 |
| 1% RE 610 surfactant [ml/l] | 10 | 10 | 10 |

All solutions were adjusted to a final volume of 2 liters and were subsequently aerated with air at a rate of 0.5 cubic foot per hour. Four silicon wafers were processed with the copper activation process as description above and after that each one was subsequently introduced in one of the respective test solutions outlined in table 2 and under the conditions described above for the copper electroless process.

The test solution used in Example 6 resulted in a low copper deposition rate of below 1 µm/h after 240 minutes. Good results were obtained with the test solutions used in Examples 7 and 8 which resulted in a copper deposition rate of 3 µm/h after 126 minutes.

Furthermore, glyoxylic acid was tested as reducing agent. In a solution where formaldehyde was replaced by glyoxylic acid the pH adjustment was difficult and all results from these tests showed an increased bond failure after wire bonder process.

**Table 3: Composition of electroless copper plating solutions with different surfactants.**

| | Ex. 9 | Ex.10 | Comp.Ex.11 |
|---|---|---|---|
| CuSO₄ × 5H₂O [mol/l] | 0.03 | 0.03 | 0.03 |
| EDTA acid [mol/l] | 0.089 | 0.089 | 0.089 |
| Formaldehyde [mol/l] | 0.123 | 0.123 | 0.123 |
| KOH [pH at 50°C] | 12 | 12 | 12 |
| K₃[Fe(CN)₆] [mg/l] | 400 | 400 | 400 |
| surfactant: | RE 610 | X-100 | D-8390 |
| amount (1%) | 20 ml/l | 10 ml/l | 10 ml/l |

D-8390 denotes DOWFAX® 8390 an anionic surfactant obtained from Dow. X-100 denotes Triton® X-100 obtained from Dow.

RE 610 denotes RHODAFAC® RE 610 obtained from Rhodia.

All solutions were adjusted to a final volume of 2 liters and were subsequently aerated with air at a rate of 0.5 cubic foot per hour. Three silicon wafers were processed with the copper activation process as description above and after that each one was subsequently introduced in one of the respective test solutions outlined in table 3 under the conditions described above for the copper electroless process.

An increase of the amount of RHODAFAC® RE 610 did not result in a significantly increased copper deposition rate. The test solution used in Example 9 resulted in a copper deposition rate of 3 µm/h after 126 minutes.

Good results were also obtained with the test solution used in Example 10, where RHODAFAC® RE 610 was replaced by another non-ionic surfactant Triton® X-100 which resulted in a copper deposition rate of 3 µm/h after 126 minutes.

The test solution used in Comparative Example 11 became instable and copper precipitation from the copper plating solution occurred when an anionic detergent was used instead of a non-ionic detergent. DOWFAX® 8390 is an alkyldiphenyloxide disulfonate, with a linear alky group with 16 C-atoms.

**Table 4: Electroless copper plating solutions with different agents for adjusting the pH**

| | Ex.12 | Comp.Ex.13 | Comp.Ex.14 |
|---|---|---|---|
| CuSO₄ × 5H₂O [mol/l] | 0.03 | 0.03 | 0.03 |
| EDTA acid [mol/l] | 0.089 | 0.089 | 0.089 |
| Formaldehyde [mol/l] | 0.123 | 0.123 | 0.123 |
| agent for adjusting the pH to 11,5 at 50°C | KOH | NaOH | NaOH/TMAH |
| K₃[Fe(CN)₆] [mg/l] | 400 | 400 | 400 |
| 1% RE 610 surfactant [ml/l] | 10 | 10 | 10 |

All solutions were adjusted to a final volume of 2 liters and were subsequently aerated with air at a rate of 0.5 cubic foot per hour. Three silicon wafers were processed with the copper activation process as description above and after that each one was subsequently introduced in one of the respective test solutions outlined in table 4 under the conditions described above for the copper electroless process.

Potassium hydroxide, sodium hydroxide or TMAH (tetramethylammonium hydroxide) were used as agents for adjusting the pH.

The use of potassium hydroxide in the test solution used in Example 12 resulted in bright copper layers, which was deposited with a deposition rate of 3 µm/h after 126 minutes. The use of sodium hydroxide or sodium hydroxide and TMAH in Comparative Examples 13 and 14 resulted in the deposition of copper layers with a very dark surface caused by a change of its morphology and copper surface oxidation.

**Table 5: Electroless copper plating solutions with different pH**

| | Ex.15 | Ex.16 | Ex.17 | Comp.Ex.18 |
|---|---|---|---|---|
| CuSO₄ × 5H₂O [mol/l] | 0.03 | 0.03 | 0.03 | 0.03 |
| EDTA acid [mol/l] | 0.089 | 0.089 | 0.089 | 0.089 |
| Formaldehyde [mol/l] | 0.123 | 0.123 | 0.123 | 0.123 |
| KOH [pH at 50°C] | 11.5 | 12 | 12.5 | 13 |
| K₃[Fe(CN)₆] [mg/l] | 400 | 400 | 400 | 400 |
| 1% RE 610 surfactant [ml/l] | 10 | 10 | 10 | 10 |

All solutions were adjusted to a final volume of 2 liters and were subsequently aerated with air at a rate of 0.5 cubic foot per hour. Four silicon wafers were processed with the copper activation process as description above and after that each one was subsequently introduced in one of the respective test solutions outlined in table 5 under the conditions described above for the copper electroless process.

The test solution used in Comparative Example 18 became instable and copper precipitation from the copper bath solution occurred.

After the designated time points, the respective wavers were removed from the copper plating solution and the thickness of the deposited copper layer was measured.

After the deposition was finished, the curvature of the deposited copper layer was determined.

The respective thickness as well as the curvature of the deposited copper layers and the deposition rates obtained with the test solutions used in Examples 15, 16, and 17 are summarized below in Table 6a and 6b and in Figure 3:

**Table 6a Thickness and curvature of the deposited copper layers with different pH**

| | | Time (minutes): | | | | | | | Deposition rate (µm/h) | Curvature (µm) |
|---|---|---|---|---|---|---|---|---|---|---|
| | | 30 | 62 | 108 | 126 | 188 | 206 | 240 | | |
| pH | Thickness (µm): | | | | | | | | | |
| 11.5 | | 1.4 | 2.5 | 3.7 | 4.2 | n.d. | n.d. | 5.8 | 1.45 ⁽¹⁾ | 20 ⁽¹⁾ |
| 12.0 | | 2.2 | 5.1 | 5.9 | 6.6 | 8.38 | 8.97 | n.d. | 2.61 ⁽²⁾ | 22 ⁽²⁾ |
| 12.5 | | 3.1 | 5.4 | 7.6 | 8.16 | n.d. | n.d. | n.d. | 3.89 ⁽³⁾ | 19 ⁽³⁾ |

| | | | | | | | | | | |
|---|---|---|---|---|---|---|---|---|---|---|
| ⁽¹⁾ = after 240 minutes ⁽²⁾ = after 206 minutes ⁽³⁾ = after 126 minutes n.d. = not determined | | | | | | | | | | |

**Table 6b: Thickness and deposition rate of the deposited copper layers with different pH**

| | Time (minutes): | | | | | | |
|---|---|---|---|---|---|---|---|
| | 30 | 62 | 108 | 126 | 188 | 206 | 240 |
| pH 11,5: | | | | | | | |
| Thickness (µm): | 1.4 | 2.5 | 3.7 | 4.2 | n.d. | n.d. | 5.8 |
| Deposition rate (µm/h) | 2.8 | 2.42 | 2.06 | 2 | n.d. | n.d. | 1.45 |
| pH 12,0: | | | | | | | |
| Thickness (µm): | 2.2 | 5.1 | 5.9 | 6.6 | 8.38 | 8.97 | n.d. |
| Deposition rate (µm/h) | 4.4 | 4.94 | 3.28 | 3.14 | 2.67 | 2.61 | n.d. |
| pH 12,5: | | | | | | | |
| Thickness (µm): | 3.1 | 5.4 | 7.6 | 8.16 | n.d. | n.d. | n.d. |
| Deposition rate (µm/h) | 6.2 | 5.23 | 4.22 | 3.89 | n.d. | n.d. | n.d. |

| | | | | | | | |
|---|---|---|---|---|---|---|---|
| n.d. = not determined | | | | | | | |

The use of potassium hydroxide to adjust the pH to 12,5 at 50°C resulted in a further increased deposition rate. After 126 minutes a copper layer with a thickness of 8.16 µm and a curvature of 19 µm was obtained.

### Example 19: Annealing of copper layer

Metallic coatings applied by electroless methods onto a different substrate material can exhibit a degree of stress that may be compressive or tensile. When the degree of stress is high, it is very common to see some surface defects such as cracks.

Furthermore, due to inclusion of impurities into the natural lattice structure of the metallic coating the occurrence of internal stress is also possible.

Thus, for the metallic coatings obtained by an electroless process is necessary to minimize the stress level, which is achieved by annealing the copper layer after deposition.

A silicon wafer was processed as outlined above. The test solution used in Example 17 having the composition described in Table 5 was used as copper plating solution. After deposition of a copper layer the silicon wafer was rinsed.

After rinsing, the respective silicon wafer coated with a copper layer was annealed at a Temperature of 250°C for 110 minutes.

Before and after annealing the roughness of the deposited copper layer of three square diode chips was tested using the surface roughness measurement instrument Surftest SJ-210 obtained from Mitutoyo. The results are summarized below in Table 7:

**Table 7 Surface roughness before and after annealing.**

| **before annealing process** | | | |
|---|---|---|---|
| | Rₐ | R_{z} | R_{q} |
| 1 | 2.31 | 8.68 | 2.85 |
| 2 | 2.35 | 9.32 | 3.22 |
| 3 | 1.96 | 8.72 | 2.60 |

| **after annealing process** | | | |
|---|---|---|---|
| | Rₐ | R_{z} | R_{q} |
| 1 | 1.48 | 7.11 | 2.18 |
| 2 | 1.42 | 7.10 | 1.92 |
| 3 | 1.27 | 6.54 | 1.7 |

The results obtained after the annealing process showed a high variation between the roughness measured before and after the heat treatment.

Copper films prepared by electroless plating are usually not as ductile as bulk copper since they contain numerous pockets of hydrogen gas in the metal matrix. The inclusion of hydrogen gas can result in two types of embrittlement, generated by voids formed in the deposited copper film and a pressure effect.

The presence of voids reduces the film ductility by offering preferential sites for stress concentration. Furthermore, during electroless copper deposition, hydrogen can be readily co-deposited in atomic as well as molecular form in the voids.

With low-temperature annealing, hydrogen diffuses out of the copper interstitially via a dissociative reaction at the surface of the void. The out-diffusion of hydrogen further removes the pressure effect and caused a variation in curvature as depicted in Table 6a above.

### Example 20: Electroless deposition of Cu on glass passivated diode chips

Silicon wafers manufactured by float zone process were obtained from Siltronic AG (München, DE) with the following characteristics:
- diameter from 4 inches (101.6 mm) up to 6 inches (152.4 mm),
- thickness from 300 µm up to 350 µm,
- crystal orientation: 1-1-1,
- resistivity range 40 to 100 ohm.

For further testing square diode chips with a size of 5.6 mm x 5.6 mm and having one pn-junction were processed into the silicon wafers by methods known in the art.

The square diode chips were provided with a first contact metal layer 22 and a second contact metal layer 24 consisting of nickel, respectively.

Furthermore, the gap formed at the first surface 160 between p-doped volume 16 and the borders 100 of semiconductor component 10 was coated with a glass passivation layer in order to prevent deposition of contact metal and/or copper in that area.

Prior to the copper electroless process, the glass passivation layer was coated with a mixture of two different coating types wepelan plating resist SD 2154E obtained from Lackwerke Peters GmbH and Rhenodux-Screen-ink 220-CX-220449 obtained from Lackfabrik Hoefer GmbH.

Both coating resins were mix in a ratio of 1:1 before application.

The coating layer covered the passivation layer to avoid any kind of contamination during the copper electroless process.

The coating was applied by screen printing technique. Screen printing is a printing technique that uses a woven mesh to support an ink-blocking stencil. The attached polyester stencil forms open areas of 90 mesh, so that transfer ink or other printable materials can be pressed through the mesh as a sharp-edged image onto a substrate. A roller or squeegee with 75 Shore A hardness with rectangular profile is moved across the screen stencil with angle of 70°, forcing or pumping ink past the threads of the woven mesh in the open areas.

After screen printing the coating is dried for 20 minutes in circulating hot air at a temperature of 100°C.

After drying of the resin, the coated diode chips where dipped into an acidic, aqueous solution comprising 0.00175 g/l PdCl₂ and having a pH of 0 for 4 minutes at a temperature of about 25 °C, followed by a short rinsing step with deionized water for 10 sec.

After rinsing, the coated diode chips where further dipped into an aqueous formaldehyde solution containing 100g/l formaldehyde having a pH of 4.5 for 4 minutes at a temperature of about 25°C, followed by a short rinsing step with dionised water for 10 sec.

After rinsing, the diode chips were subjected to a copper plating solutions for 120 up to 180 minutes at a temperature of about 63°C - 68°C, followed by a short rinsing step with deionised water for 10 sec.

The test solution used in Example 17 having the composition described in Table 5 was used as copper plating solution.

After rinsing, the respective diode chips coated with a copper layer were annealed at 250°C for 180 minutes.

Before and after annealing the resistivity and the roughness were tested as outlined above.

Furthermore, after annealing the film stress measurements were performed as outline above.

### Example 21: Wire bonding

The coated glass passivated diode chips obtained in Example 20 were further subjected to a wire-bonding test.

The wire-bonding test was perfomed using an Orthodyne model 20 manual bonding machine (Kulicke & Soffa Orthodyne Electronics Inc., Irvine, USA) using commercially available Aluminum wires obtained from Heraeus Materials Technology GmbH & Co. KG (Hanau, DE) having a diameter of 300 µm

To investigate the wire-bondability performance of in semiconductor devices, an Orthodyne Electronics Model 20 semiautomatic wire bonder was used in this work. Several tests were performed to evaluate the bonding time, bonding power, bonding force and substrate temperature.

Wire bonding was done with an aluminum wire having a diameter of 300 µm by applying a bonding pressure (Pr) of 400 gf (gram force), 600 gf, or 800 gf, repectively. Substrate temperature and bonding time were fixed in each case at 25°C and 125 ms, respectively. The bonding power used was 100 arbitrary units (a.u.), 150 a.u., 200 a.u., 250 a.u., 275 a.u., or 300 a.u., respectively, with 0.1 s of applied power.

The resulting wire bonds were tested by the following procedure:
The principle behind wire bond testing is positioning of a hook underneath the wire and applying a force F_{R} in the Z axis either until the bond breaks (destructive testing) or a predefined force is reached (non-destructive testing) as illustrated in Figure 4.

Wire bond testing is covered by the external standard MIL-STD-883G (Method 2011.7 for destructive testing and 2023.5 for non-destructive)

Destructive pull test was done in accordance with method 2011.7, bond pull strength test, which is a method to evaluate the bond strength by hooking and pulling the bonded wire until failure occurs.

The purpose of this test is to examine the bond strength and to certify the proper setup of the bonding machine parameters. The results are important evidences for evaluating bonding quality and reliability, as well as understanding bond failure mechanisms including flexure failures, interfacial de-adhesion, cratering, and shear fatigue at bonded interfaces during temperature cycling.

Wire pull tests were performed manually

Figure 5 shows the rupture force necessary for bond break as a function of bonding power and bonding pressure for Cu-coated glass passivated diode chips which were wire bonded with an aluminum wire having a diameter of 300 µm. All Bondings were done with the indicated bonding pressure (Pr) of 400 gf (gram force), 600 gf or 800 gf, respectively, and a bonding power between 100 to 300 arbitrary units (a.u.).

The minimum bond strength as specified by MIL STD 750B, method 2037, is 140 gf for an aluminum wire with 300 µm diameter.

No bonding failed below 140 gf, even when the wire bonding was achieved by applying a bonding power of 100 a.u. and bonding pressure of 400 gf.

Figure 6 shows the distribution of bonding failures as a function of pulling force of Cu-coated glass passivated diode chips which were wire bonded with an aluminum wire having a diameter of 300 µm. All the bondings were done with 600 gf of pressure and power of 200 a.u. and with 0.1 s of applied power. No bonding failed below 140 gf.

## Claims

1. A method for electroless deposition of a copper-layer (20) on a semiconductor substrate (1) comprising the steps of
a) providing a semiconductor substrate (1),
b) contacting said semiconductor substrate (1) with an aqueous solution comprising at least one colloidal metal and/or salt of a metal, said metal being selected from the group consisting of Ag, Au, Pd, Pt, Rh and mixtures thereof,
c) optionally, rinsing said semiconductor substrate obtained in step b),
d) contacting said semiconductor substrate (1) with an aqueous solution containing at least one reducing agent,
e) optionally, rinsing said semiconductor substrate obtained in step d),
f) contacting said semiconductor substrate (1) with a copper plating solution containing
at least one water soluble copper salt,
at least one complexing agent for copper ions,
at least one reducing agent,
at least one agent for adjusting the pH to a value of greater than 9.0
with the proviso that the agent is not NaOH
at least one water soluble cyano metal compound,
at least one non-ionic surfactant, and
water,
at a temperature below the boiling point of the copper plating solution resulting in the formation of a copper-layer (20),
g) optionally, rinsing said semiconductor substrate obtained in step f), and
h) annealing said copper-layer (20).

2. The method according to claim 1 wherein said water soluble copper salt is a water soluble copper (II) salt preferably selected from the group consisting of CuSO₄, CuCl₂, Cu(NO₃)₂, Cu(BF₄)₂, Cu(OAc)₂ and mixtures thereof.

3. The method according to any of claims 1 or 2 wherein said at least one water soluble cyano metal compound is selected from the group consisting of A₃[M³⁺(CN)₆], A₄[M²⁺(CN)₆] and mixtures thereof, wherein A is selected from the group consisting of Na⁺, K⁺, Li⁺, NH₄⁺ and mixtures thereof and M is selected from the group consisting of Fe, Mn, Cr, Co and mixtures thereof.

4. The method according to any of claims 1 to 3 wherein the at least one nonionic surfactant is selected from the group consisting of polyoxyalkylene glycol aryl ethers, polyoxyalkylene glycol alkyl ethers, polyoxyalkylene glycol alkylaryl ethers and phosphates thereof and mixtures thereof.

5. The method according to claim 4 wherein said polyoxyalkylene glycol alkylaryl ether phosphate is a polyethoxy nonylphenoxy ether phosphate having from 5 to 21 ethylene oxide units.

6. The method according to claim 4 wherein said polyoxyalkylene glycol alkylaryl ether is a polyethylene glycol-[4-(1,1,3,3-tetramethylbutyl)-phenyl]-ether having 5 to 21 ethylene oxide units.

7. The method according to any of claims 1 to 6 wherein said at least one reducing agent is selected from the group consisting of formaldehyde, glyoxylic acid and mixtures thereof.

8. The method according to any of claims 1 to 7 wherein said semiconductor substrate (1) having a first surface (160) and an opposite second surface (140) comprises a plurality of semiconductor components (10), wherein each of said semiconductor components (10) comprises at least one pn-junction having at least one p-doped volume (16) and at least one n-doped volume (12, 14), wherein said at least one p-doped volume (16), optionally coated with a first contact metal layer (22), is arranged at said first surface (160) of said substrate (1) forming a first contact-area (162, 163) and wherein said at least one n-doped volume (14), optionally coated with a second contact metal layer (24), is arranged at said second surface (140) of said substrate (1) forming a second contact-area (143).

9. The method according to claim 8 wherein said first contact metal layer (22) and/or said second contact metal layer (24) is an adhesion promoting layer having a thickness of less than 500 nm and preferably containing Nickel.

10. The method according to any of claims 8 or 9 wherein said plurality of semiconductor components (10) are arranged in a wafer assembly.

11. The method according to claim 10 wherein said second contact-areas (143) of all semiconductor components (10) of the wafer assembly are in direct contact to each other forming a continuous contact-area.

12. The method according to any of claims 10 or 11 wherein said first contact-areas (162, 163) of all semiconductor components (10) of the wafer assembly are spaced to each other forming a discontinuous contact-area.

13. An electroless deposited copper layer suitable for wire-bonding obtainable by the method according to any one of claims 1 to 12 and having a thickness of from 3.0 µm to 11 µm, preferably of from 4.0 µm to 9.0 µm.

14. The electroless deposited copper layer according to claim 13 wherein said copper-layer consists of at least 90 % by weight, preferably of 100 % by weight, of copper.

15. The electroless deposited copper layer according to any of claims 13 or 14 wherein said copper-layer has a surface roughness of from 2% to 5% of the total thickness of the layer.

16. A semiconductor component (10) having a first surface (160) and an opposite second surface (140) comprising at least one pn-junction having at least one p-doped volume (16) and at least one n-doped volume (12, 14), wherein said at least one p-doped volume (16), optionally coated with a first contact metal layer (22), is arranged at said first surface (160) of said semiconductor component (10) forming a first contact-area (162, 163) and wherein said at least one n-doped volume (14), optionally coated with a second contact metal layer (24), is arranged at said second surface (140) of said semiconductor component (10) forming a second contact-area (143) and wherein an electroless deposited copper-layer (20) according to any one of claims 13 to 15 is arranged on said first contact-area (162, 163).

## Patentansprüche

1. Verfahren zum stromlosen Abscheiden einer Kupferschicht (20) auf einem Halbleitersubstrat (1), umfassend die folgenden Stufen:
a) Bereitstellen eines Halbleitersubstrats (1),
b) Kontaktieren des Halbleitersubstrats (1) mit einer wässrigen Lösung, die mindestens ein kolloidales Metall und/oder Salz eines Metalls umfasst, wobei das Metall aus der Gruppe ausgewählt ist, die besteht aus Ag, Au, Pd, Pt, Rh und Gemischen davon,
c) gegebenenfalls Spülen des in Stufe b) erhaltenen Halbleitersubstrats,
d) Kontaktieren des Halbleitersubstrats (1) mit einer wässrigen Lösung, die mindestens ein Reduktionsmittel enthält,
e) gegebenenfalls Spülen des in Stufe d) erhaltenen Halbleitersubstrats,
f) Kontaktieren des Halbleitersubstrats (1) mit einer Kupferplattierungslösung, die Folgendes enthält
mindestens ein wasserlösliches Kupfersalz,
mindestens ein Komplexierungsmittel für Kupferionen,
mindestens ein Reduktionsmittel,
mindestens ein Mittel zur Einstellung eines pH-Werts von mehr als 9,0, mit der Maßgabe, dass es sich bei dem Mittel nicht um NaOH handelt,
mindestens eine wasserlösliche Cyanometallverbindung,
mindestens ein nicht-ionisches Tensid und
Wasser,
bei einer Temperatur unterhalb des Siedepunkts der Kupferplattierungslösung unter Bildung einer Kupferschicht (20),
g) gegebenenfalls Spülen des in Stufe f) erhaltenen Halbleitersubstrats und
h) Tempern der Kupferschicht (20).

2. Verfahren nach Anspruch 1, wobei es sich beim wasserlöslichen Kupfersalz um ein wasserlösliches Kupfer(II)-Salz handelt, das vorzugsweise aus der Gruppe ausgewählt ist, die besteht aus CuSO₄, CuCl₂, Cu(NO₃)₂, Cu(BF₄)₂, Cu(OAc)₂ und Gemischen davon.

3. Verfahren nach einem der Ansprüche 1 oder 2, wobei die mindestens eine wasserlösliche Cyanometallverbindung aus der Gruppe ausgewählt ist, die besteht aus A₃[M³⁺(CN)₆], A₄[M²⁺(CN)₆] und Gemischen davon, wobei A aus der Gruppe ausgewählt ist, die besteht aus Na⁺, K⁺, Li⁺, NH₄⁺ und Gemischen davon und M aus der Gruppe ausgewählt ist, die besteht aus Fe, Mn, Cr, Co und Gemischen davon.

4. Verfahren nach einem der Ansprüche 1 bis 3, wobei das mindestens eine nicht-ionische Tensid aus der Gruppe ausgewählt ist, die besteht aus Polyoxyalkylenglycolarylethern, Polyoxyalkylenglycolalkylethern, Polyoxyalkylenglycolalkylarylethern und Phosphaten davon sowie Gemischen davon.

5. Verfahren nach Anspruch 4, wobei es sich beim Polyoxyalkylenglycolalkylaryletherphosphat um ein Polyethoxynonylphenoxyetherphosphat mit 5 bis 21 Ethylenoxid-Einheiten handelt.

6. Verfahren nach Anspruch 4, wobei es sich beim Polyoxyalkylenglycolalkylarylether um Polyethylenglycol-[4-(1,1,3,3-tetramethylbutyl)-phenyl]-ether mit 5 bis 21 Ethylenoxid-Einheiten handelt.

7. Verfahren nach einem der Ansprüche 1 bis 6, wobei das mindestens eine Reduktionsmittel aus der Gruppe ausgewählt ist, die besteht aus Formaldehyd, Glyoxylsäure und Gemischen davon.

8. Verfahren nach einem der Ansprüche 1 bis 7, wobei das Halbleitersubstrat (1) mit einer ersten Oberfläche (160) und einer gegenüberliegenden zweiten Oberfläche (140) eine Mehrzahl von Halbleiterkomponenten (10) umfasst, wobei jede der Halbleiterkomponenten (10) mindestens einen pn-Übergang mit mindestens einem p-dotierten Volumen (16) und mindestens einem n-dotierten Volumen (12, 14) umfasst, wobei das mindestens eine p-dotierte Volumen (16), das gegebenenfalls mit einer ersten Kontaktmetallschicht (22) beschichtet ist, auf der ersten Oberfläche (160) des Substrats (1) unter Bildung einer ersten Kontaktfläche (162, 163) angeordnet ist und wobei das mindestens eine n-dotierte Volumen (14), das gegebenenfalls mit einer zweiten Kontaktmetallschicht (24) beschichtet ist, auf der zweiten Oberfläche (140) des Substrats (1) unter Bildung einer zweiten Kontaktfläche (143) angeordnet ist.

9. Verfahren nach Anspruch 8, wobei es sich bei der ersten Kontaktmetallschicht (22) und/oder der zweiten Kontaktmetallschicht (24) um eine haftungsfördernde Schicht mit einer Dicke von weniger als 500 nm, die vorzugsweise Nickel enthält, handelt.

10. Verfahren nach einem der Ansprüche 8 oder 9, wobei die Mehrzahl von Halbleiterkomponenten(10) in einer Wafer-Anordnung angeordnet ist.

11. Verfahren nach Anspruch 10, wobei die zweiten Kontaktflächen (143) sämtlicher Halbleiterkomponenten (10) der Wafer-Anordnung in direktem Kontakt miteinander unter Bildung einer kontinuierlichen Kontaktfläche stehen.

12. Verfahren nach einem der Ansprüche 10 oder 11, wobei die ersten Kontaktflächen (162, 163) sämtlicher Halbleiterkomponenten (10) der Wafer-Anordnung im Abstand voneinander unter Bildung einer diskontinuierlichen Kontaktfläche angeordnet sind.

13. Stromlos abgeschiedene Kupferschicht, die zum Drahtbonden geeignet ist, die durch ein Verfahren nach einem der Ansprüche 1 bis 12 erhältlich ist und die eine Dicke von 3,0 µm bis 11 µm und vorzugsweise von 4,0 µm bis 9,0 µm aufweist.

14. Stromlos abgeschiedene Kupferschicht nach Anspruch 13, wobei die Kupferschicht aus mindestens 90 Gew.-% und vorzugsweise 100 Gew.-% Kupfer besteht.

15. Stromlos abgeschiedene Kupferschicht nach einem der Ansprüche 13 oder 14, wobei die Kupferschicht eine Oberflächenrauigkeit von 2 % bis 5 % der Gesamtdicke der Schicht aufweist.

16. Halbleiterkomponente (10) mit einer ersten Oberfläche (160) und einer gegenüberliegenden zweiten Oberfläche (140), umfassend mindestens einen pn-Übergang mit mindestens einem p-dotierten Volumen (16) und mindestens einem n-dotierten Volumen (12, 14), wobei das mindestens eine p-dotierte Volumen (16), das gegebenenfalls mit einer ersten Kontaktmetallschicht (22) beschichtet ist, auf der ersten Oberfläche (160) der Halbleiterkomponente (10) unter Bildung einer ersten Kontaktfläche (162, 163) angeordnet ist und wobei das mindestens eine n-dotierte Volumen (14), das gegebenenfalls mit einer zweiten Kontaktmetallschicht (24) beschichtet ist, auf der zweiten Oberfläche (140) der Halbleiterkomponente (10) unter Bildung einer zweiten Kontaktfläche (143) angeordnet ist und wobei eine stromlos abgeschiedene Kupferschicht (20) nach einem der Ansprüche 13 bis 15 auf der ersten Kontaktfläche (162, 163) angeordnet ist.

## Revendications

1. Procédé de déposition anélectrolytique d'une couche de cuivre (20) sur un substrat semi-conducteur (1), comprenant les étapes consistant à
a) disposer d'un substrat semi-conducteur (1),
b) mettre le substrat semi-conducteur (1) en contact avec une solution aqueuse comprenant au moins un métal et/ou sel d'un métal à l'état colloïdal, ledit métal étant choisi dans le groupe constitué par Ag, Au, Pd, Pt, Rh et leurs mélanges,
c) éventuellement rincer ledit substrat semi-conducteur obtenu dans l'étape b),
d) mettre ledit substrat semi-conducteur (1) en contact avec une solution aqueuse contenant au moins un agent réducteur,
e) éventuellement rincer ledit substrat semi-conducteur obtenu dans l'étape d),
f) mettre ledit substrat semi-conducteur (1) en contact avec un bain de cuivrage contenant
au moins un sel de cuivre soluble dans l'eau,
au moins un agent complexant les ions cuivre,
au moins un agent réducteur,
au moins un agent pour ajuster le pH à une valeur supérieure à 9,0 sous réserve que l'agent ne soit pas le NaOH,
au moins un composé cyanométallique soluble dans l'eau,
au moins un tensioactif non-ionique, et
de l'eau,
à une température inférieure au point d'ébullition du bain de cuivrage, ayant pour résultat la formation d'une couche de cuivre (20),
g) éventuellement rincer ledit substrat semi-conducteur obtenu dans l'étape f), et
h) recuire ladite couche de cuivre (20).

2. Procédé selon la revendication 1, dans lequel ledit sel de cuivre soluble dans l'eau est un sel de cuivre(II) soluble dans l'eau choisi de préférence dans le groupe constitué par CuSO₄, CuCl₂, Cu(NO₃)₂, Cu(BF₄)₂, Cu(OAc)₂ et leurs mélanges.

3. Procédé selon l'une quelconque des revendications 1 et 2, dans lequel ledit au moins un composé cyanométallique soluble dans l'eau est choisi dans le groupe constitué par A₃[M³⁺(CN)₆], A₄[M²⁺(CN)₆] et leurs mélanges, où A est choisi dans le groupe constitué par Na⁺, K⁺, Li⁺, NH₄⁺ et leurs mélanges, et M est choisi dans le groupe constitué par Fe, Mn, Cr, Co et leurs mélanges.

4. Procédé selon l'une quelconque des revendications 1 à 3, dans lequel l'au moins un tensioactif non-ionique est choisi dans le groupe constitué par les éthers aryliques de polyoxyalkylèneglycol, les éthers alkyliques de polyoxyalkylèneglycol, les éthers alkylaryliques de polyoxyalkylèneglycol, et leurs phosphates, ainsi que leurs mélanges.

5. Procédé selon la revendication 4, dans lequel ledit phosphate d'éther alkylarylique de polyoxyalkylèneglycol est un phosphate de nonylphénoxyéther polyéthoxylé ayant de 5 à 21 motifs oxyde d'éthylène.

6. Procédé selon la revendication 4, dans lequel ledit éther alkylarylique de polyoxyalkylèneglycol est un éther 4-(1,1,3,3-tétraméthylbutyl)phénylique de polyéthylèneglycol ayant 5 à 21 motifs oxyde d'éthylène.

7. Procédé selon l'une quelconque des revendications 1 à 6, dans lequel ledit au moins un agent réducteur est choisi dans le groupe constitué par le formaldéhyde, l'acide glyoxylique et leurs mélanges.

8. Procédé selon l'une quelconque des revendications 1 à 7, dans lequel ledit substrat semi-conducteur (1) ayant une première surface (160) et une deuxième surface opposée (140) comprend une pluralité de composants semi-conducteurs (10), dans lequel chacun desdits composants semi-conducteurs (10) comprend au moins une jonction pn ayant au moins un volume p-dopé (16) et au moins un volume n-dopé (12, 14), dans lequel au moins un volume p-dopé (16), éventuellement revêtu d'une première couche métallique de contact (22), est disposé au niveau de ladite première surface (160) dudit substrat (1) en formant une première zone de contact (162, 163), et dans lequel ledit au moins un volume n-dopé (14), éventuellement revêtu d'une deuxième couche métallique de contact (24), est disposé au niveau de ladite deuxième surface (140) dudit substrat (1) en formant une deuxième zone de contact (143).

9. Procédé selon la revendication 8, dans lequel ladite première couche métallique de contact (22) et/ou ladite deuxième couche métallique de contact (24) sont des couches promotrices d'adhérence ayant une épaisseur inférieure à 500 nm et contenant de préférence du nickel.

10. Procédé selon l'une quelconque des revendications 8 et 9, dans lequel ladite pluralité de composants semi-conducteurs (10) est agencée dans un assemblage de galette.

11. Procédé selon la revendication 10, dans lequel lesdites deuxièmes zones de contact (143) de tous les composants semi-conducteurs (10) de l'assemblage de galette sont en contact direct les unes avec les autres en formant une zone de contact continue.

12. Procédé selon l'une quelconque des revendications 10 et 11, dans lequel lesdites premières zones de contact (162, 163) de tous les composants semi-conducteurs (10) de l'assemblage de galette sont espacées les unes des autres en formant une zone de contact discontinue.

13. Couche de cuivre déposée par voie autocatalytique convenant pour le microcâblage, pouvant être obtenue par le procédé de l'une quelconque des revendications 1 à 12 et ayant une épaisseur de 3,0 µm à 11 µm, de préférence de 4,0 µm à 9,0 µm.

14. Couche de cuivre déposée par voie anélectrolytique selon la revendication 13, laquelle couche de cuivre est constituée à au moins 90 % en poids, de préférence à 100 % en poids, de cuivre.

15. Couche de cuivre déposée par voie autocatalytique selon l'une quelconque des revendications 13 et 14, laquelle couche de cuivre a une rugosité de surface de 2 % à 5 % de l'épaisseur totale de la couche.

16. Composant semi-conducteur (10) ayant une première surface (160) et une deuxième surface opposée (140) comprenant au moins une jonction pn ayant au moins un volume p-dopé (16) et au moins un volume n-dopé (12, 14), dans lequel au moins un volume p-dopé (16), éventuellement revêtu d'une première couche métallique de contact (22), est disposé au niveau de ladite première surface (160) dudit composant semi-conducteur (10) en formant une première zone de contact (162, 163), et dans lequel ledit au moins un volume n-dopé (14), éventuellement revêtu d'une deuxième couche métallique de contact (24), est disposé au niveau de ladite deuxième surface (140) dudit composant semi-conducteur (10) en formant une deuxième zone de contact (143), et dans lequel une couche de cuivre déposée par voie autocatalytique (20) selon l'une quelconque des revendications 13 à 15 est disposée sur ladite première zone de contact (162, 163).
